# EUROPEAN PATENT SPECIFICATION

(11) **EP 2 259 301 B1**
(45) Date of publication and mention of the grant of the patent: **19.08.2020**
(21) Application number: 10177601.1
(22) Date of filing: 14.10.2004
(51) Int. Cl.: H01L 21/304, H01L 21/762, H01L 23/544

(54) **Method for preparing and assembling substrates**
Verfahren zur Vorbereitung und zum Zusammenbau von Substraten
Procédé de préparation et d'assemblage de substrats

(30) Priority: 14.10.2003 FR 0350674; 07.05.2004 US 56870004 P
(43) Date of publication of application: 08.12.2010
(62) Divisional of application: 04791232.4
(73) Proprietor: Soitec, 38190 Bernin (FR)
(72) Inventor: Aspar, Bernard, 38300 Saint-Ismier (FR); Lagahe-Blanchard, Chrystelle, 38134 Saint-Joseph-de-Rivière (FR)
(74) Representative: Ilgart, Jean-Christophe

(56) References cited:
- EP-A1- 1 507 292
- JP-A- 1 089 346
- JP-A- S6 489 346
- JP-A- 2000 173 961
- JP-A- 2003 078 115
- US-A- 5 869 386
- US-A1- 2003 094 674

## Description

### Technical field and prior art

The invention relates to the field of assembling wafers or slices or layers of material, notably semiconductors, and of their preparation with the purpose of assembling them.

Among the assembly techniques of such substrates, molecular adhesion allows to assemble flat structures of low surface roughness.

It allows to obtain unique structures and is particularly well adapted for bonding together wafers of material used in microelectronics, such as, for example, wafers in silicon, or III-V material (AsGa, InP) or glass or fused silica or vitreous fused silica glass substrates.

Nowadays this technique is used industrially, for example in the manufacture of SOI (Silicon On Insulator) material.

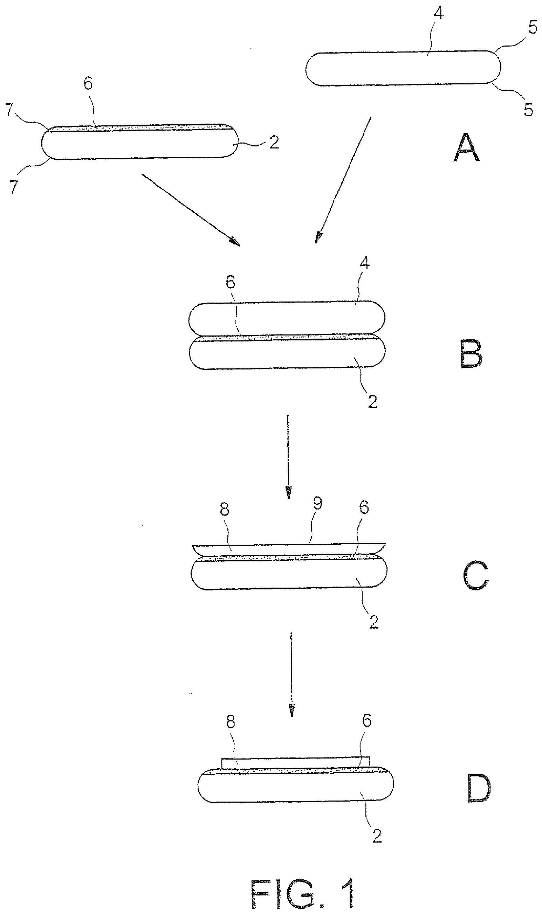

The known methods for manufacturing SOI material, which use molecular adhesion, implement two wafers 2, 4 of silicon (figure 1, part A), of which at least one of the two has a layer 6 of oxide on the surface.

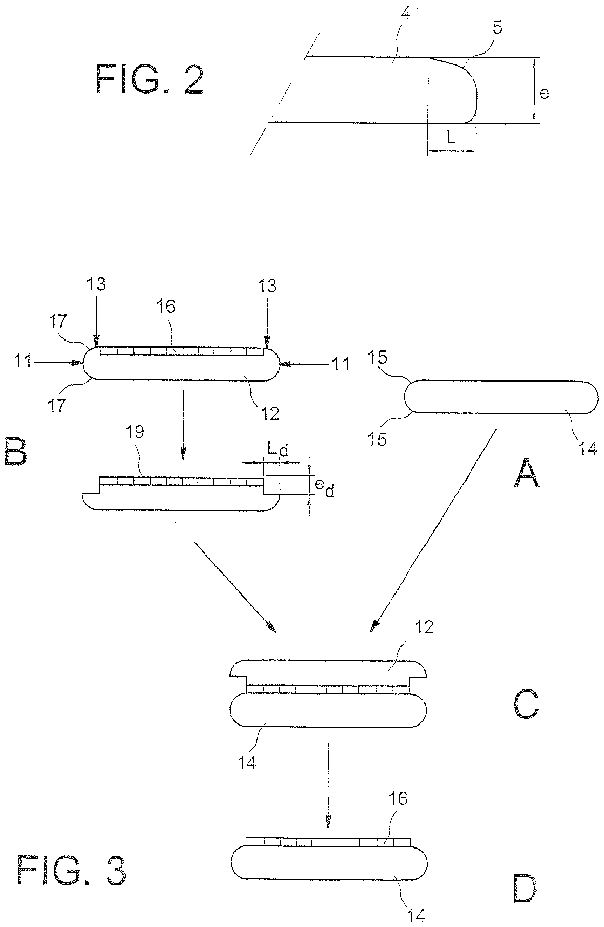

These two wafers are of standard size. The edges 5 and 7 are generally chamfered, so as to avoid fractures likely to appear during eventual manufacturing of components or in the event of shocks to still sharp edges. There are rounded and/or bevelled chamfers. Figure 2 represents, in greater detail, an example of a chamfer zone 5, of width L (measured on a plane parallel to the mean plane P of the wafer) of a wafer 4, of thickness e.

The assembling firstly comprises a surface preparation stage, a putting together stage (figure 1, part B), generally followed by a heat treatment stage.

Normally, this heat treatment is performed at 1100°C for 2 hours for SOI substrates.

Then, as illustrated in figure 1, part C, at least one of the two wafers is thinned out via surface edge grinding and/or mechanical polishing and/or mechano-chemical polishing.

The chamfers 5 and 7 generate the existence of a non-bonded zone on the wafer edges.

After thinning out, a membrane 8 made in silicon remains bonded to the centre, but detached on the edges, as visible in figure 1, part C.

The detached edge of the membrane must be removed, as it is likely to break in an uncontrolled manner and introduce particles on the other surfaces, and notably on surface 9 of the membrane 8, or on components made in the membrane 8.

For this reason a stage for routing or eliminating matter in the peripheral zone is performed in order to eliminate this edge zone from the membrane 8, as illustrated in figure 1, part D.

This routing is normally performed via mechanical means.

This stage is very delicate. For example, in the event of mechanical machining, it is difficult to route or trim everything and to stop exactly at the bonding interface, which in this case is the upper surface of the oxide layer 6. Indeed, either we stop just above this interface leaving some matter above the latter, or we stop in the support 2 and the surface polish of the edges of the front face of the support is lost.

It is therefore important to find a means of properly and accurately routing or trimming a wafer of material.

This phenomenon is also important in the case where at least one of the two wafers contains all or part of an electronic or opto-electronic device, or a micro-system, or a nano-system or another component.

The same problem exists if the assembling of the two wafers is done via bonding instead of molecular adhesion, or even without the oxide layer 6 on the surface of the wafer 12.

Another problem is the marking of one or both of the two wafers 2 and 4, generally on the support wafer, with the purpose of providing specific information such as for example identification information of a batch. For example, on SOI wafers, due to their multilayer nature, a marking, generally via etching, induces a greater number of particles than on bulk wafers.

Documents US 5 869 386 A, JP 2003 078115 A, and US 2003/094674 A1 disclose methods for assembling two semiconductor wafers wherein, before the assembling stage, orientation flats or notches are formed by a trimming step at the periphery of at least one wafer in a plane perpendicular to a main surface of the wafer.

Document JP S64 89346 A discloses a method for assembling two semiconductor wafers wherein a trimming step at the periphery of the wafers are performed after the assembling stage, thereby creating a flattened zone on the periphery of the lower wafer in a plane parallel to the main surface of said wafer.

### PRESENTATION OF THE INVENTION

The object of the invention is a method for assembling a first and a second wafer of material, according to claim 1.

One of the wafers, for example the first, can have at least one chamfered edge.

The invention thus allows to make a specific zone, for example with the purpose of marking a wafer, the routing or trimming taking place after the assembling of the wafers.

A thinning out stage of one of the two wafers can take place before or after routing or trimming, leaving at least one layer on the other wafer.

The invention can further comprise one or several of the following characteristics or stages:
- the routing or trimming can take place over the entire thickness of the routed wafer;
- and/or at least one of the two wafers can be processed, that meaning have components or circuits;
- and/or the routing or trimming stage is performed over a width Ld, measured on a plane parallel to that of the first wafer, of between 100 µm and 5 mm;
- and/or the first or the second wafer can be chamfered, and have at least one chamfered edge;
- and/or the routing or trimming stage can be performed over a width Ld, measured on a plane parallel to that of the first wafer, at least equal to the width L of the chamfered edge, measured on the same plane;
- and/or the assembling of the two substrates can be performed via molecular adhesion or via bonding using an adhesive substance;
- and/or the routing or trimming can be performed via mechanical, chemical or mechano-chemical etching or via plasma etching or via a combination of at least two of these types of etching;
- and/or at least one of the two wafers can be made in a semiconductor material, for example in silicon or in a III-V type semiconductor material;
- and/or at least one of the two wafers can be made in Germanium or in Germanium silicon or in a piezoelectric material.

### BRIEF DESCRIPTION OF THE FIGURES

Figure 1, parts A-D, represents stages of a known method for assembling substrates.
Figure 2 represents a part of a substrate and its edge or rollover edge.
Figure 3, parts A-D, represents stages of a method which, as such, is not covered by the invention.
Figures 4, parts A-C, and 5, parts A-B, represent an alternative of a method, which, as such, is not covered by the invention.
Figure 6, parts A-E, represents an alternative of a method which, as such, is not covered by to the invention, in the case of a substrate with a weakened plane.
Figure 7, parts A-D, represents an alternative of a method not covered by the invention, in the case of a substrate with a protective or bonding layer.
Figures 8A-8D represent a front view of the routed or trimmed wafers, implemented or obtained by a method according to the invention.
Figure 9 represents a wafer of material with a lateral shoulder, not covered by the invention.
Figures 10A-10B represent a wafer with an embedding, not covered by the invention.

### EXAMPLES OF EMBODIMENTS OF THE INVENTION

Figure 3, parts A-D, represents stages of a method not covered by the invention, particular aspects of which being however possibly implemented in a method according to the invention.

Two wafers 12 and 14 are chosen, for example two wafers of semiconductor material, such as standard silicon wafers.

These wafers can typically have a thickness of between 300 µm and 800 µm. They are for example wafers of 100 mm or 200 mm or 300 mm in diameter.

For the aforementioned reasons, the edges 15 and 17 are chamfered.

Components or circuits 16 may have previously been made in the wafer 12, but the invention also relates to the case of a wafer 12 absent of any circuit, the reference 16 thus designating a layer of material to be transplanted or transferred onto the wafer 14. In figure 3, part B, the surface of this layer 16 of circuits or material to be transplanted or transferred lies flush with the surface of the wafer 12.

A routing or matter eliminating or trimming stage is then performed (figure 3, part B), starting from the face 19 of the wafer 12 (thus following a direction indicated by the arrows 13) to be assembled with the wafer 14, over a thickness ed and a width Ld. It is also possible to perform a routing or trimming in the direction indicated by the arrows 11, that meaning substantially parallel to the principal plane of the wafer 12. A routing or trimming in the two combined directions is also possible.

The width Ld is measured on a plane parallel to the mean plane of the wafer. This routing or trimming stage, performed before the assembling or transplanting stage onto the wafer 14, allows to eliminate, at least partially and from the assembly face 19 or from its lateral edges, the matter located in the peripheral zone, or located around the transplant layer 16, zone which is likely to have problems caused by the non-bonded edges.

Ld is preferably greater than or equal to the width L of the rollover edge or the chamfer (figure 2). It can be from about a few hundred µm to a few mm, for example of between 100 µm and 5 mm.

Ld is notably greater than L in the case where the non-bonding zone or zone which can not adhere to a substrate after assembling, as illustrated in stage C of figure 1, is itself greater than L.

Indeed, this "non-bonding" or "non-assembling" zone depends on the manner the rollover edge is made on the wafer 12 but also on the wafer 14.

It can also depend on the technical stages that could have been previously performed on the upper wafer 12 and on the support wafer 14. Regarding the width L, some stages can increase the width of this non-bonded zone (for example oxidising or depositing stages), others can reduce this said width (for example a levelling or flattening or polishing stage).

Ld can therefore be greater than or equal to the width of this non-bonding or non-assembling zone.

The thickness ed will be less than the thickness e of the wafer. It can be substantially equal to or greater or lesser than the thickness of the layer 16 (stage D, figure 3) or of the membrane to be obtained after the future thinning out or transplanting stage onto the wafer 14.

By way of example ed can be about a few µm or between 1 µm (or 10 µm) and 100 µm or even between 5 µm and 60 µm. As for the layer 16, it can have a thickness, for example, between 1 µm and 60 µm.

If ed is less than the thickness of the layer 16 (stage D, figure 3) or of the membrane to be obtained after the future thinning out or transplanting stage, then the assembling stage can be followed by an additional routing or trimming of the remaining section of substrate 12, as will be explained below.

The routing or trimming stage before assembling, not covered by the present invention, can be performed in a mechanical and/or chemical (notably humid) and/or mechano-chemical manner and/or via plasma. The mechanic routing can be performed for example via "edge grinding" or "edge polishing".

It then proceeds with the assembling of the two wafers (stage C, figure 3) for example via molecular adhesion.

As explained above, the assembling comprises for example a surface preparation stage, a putting into contact stage and a heat treatment stage.

This heat treatment stage is performed at a few hundred degrees Celsius, for example between 100 and 1200°C, or even 1100°C, and this for a time span from a few minutes to a few hours, for example between 10 minutes and 3 hours, or even 2 hours.

Then, as illustrated in figure 3 (stage D), at least one of the two wafers is thinned down to the desired thickness, for example over a thickness greater than or equal to e-ed, via edge grinding and/or mechanical polishing and/or mechano-chemical polishing and/or chemical polishing. In figure 3 (stage D), the thinned wafer is the previously routed wafer 13.

After thinning out of the latter, a membrane made in semiconductor material, or even the layer 16 of components or circuits, thus remains bonded or assembled to the wafer 14, towards its centre. There are no lateral membranes nor any non-bonded lateral residue. The transplanting or transferring of the layer 16 is thus better than with the technology of the prior art.

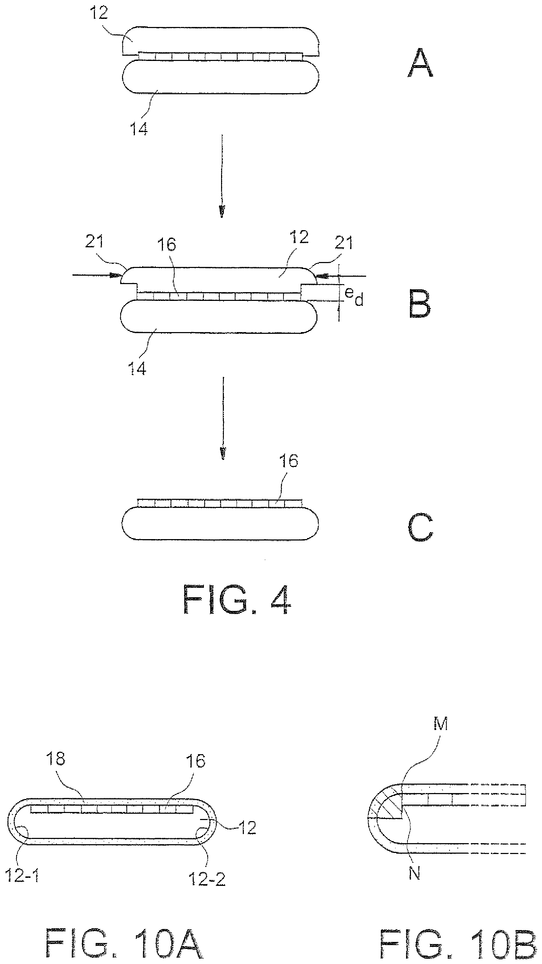

Figure 4, part A, corresponds to the aforementioned case where the depth ed over which the wafer 12 was routed before assembling (not covered by the invention) is insufficient to completely remove the layer 16 during the thinning out stage.

Assembling, which has led to the structure of figure 4, part A, can thus be followed with an additional routing or trimming, from the edges 13 located on the side of the front face or from the assembling face, in order to obtain a routed zone over a thickness ed greater than that of the layer 16 (figure 4, part B).

It is also possible to perform this additional routing or trimming from the edges 21 located on the rear face, opposite the assembling face, or even laterally, in the direction of the arrows 11 indicated in figure 4B.

This additional routing or trimming stage is free of the problems disclosed in the introduction to this application: there is notably no risk of spoiling or etching out the substrate 14. It can then be followed by the thinning out stage of the substrate 12, as described above (figure 4, part C).

Here again we obtain a transplant or a transfer free of membrane or lateral residue.

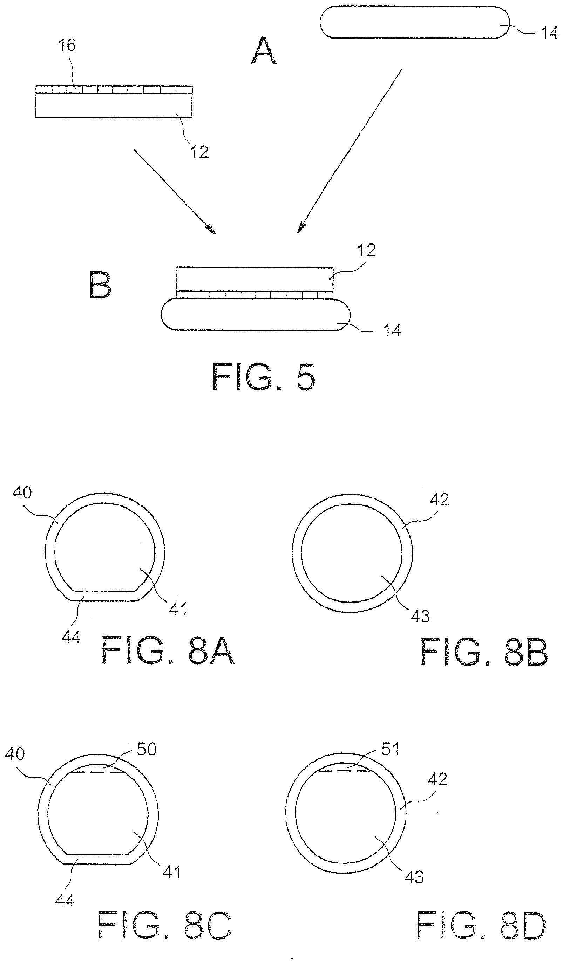

According to an alternative, which, as such, is not covered by the invention, the wafer 12 is completely routed over its entire thickness (figure 5, part A). This is the case where ed=e.

The assembling stage leads to the device represented in figure 5, part B, which can then be thinned out as explained above.

The wafer 12 then has a width or diameter less than that of the wafer 14.

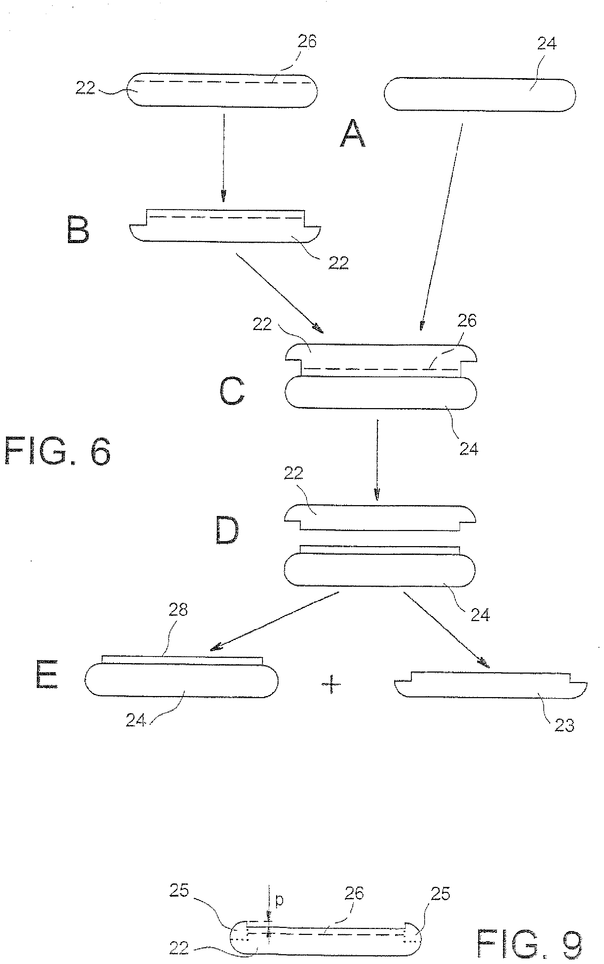

Figure 6, part A, illustrates an initial substrate 22 in which a weakened or fracture plane 26 was made, for example via previous ion implantation (for example a hydrogen implantation) or via creating a buried porous zone, as explained for example in the document by S.S.Iyer and al. "Silicon wafer bonding technology for VLST and MEMS applications", published by INSPEC, 2002, Antony Rowe Ltd, or via creating a removable bonding interface.

It then proceeds with the routing or trimming of this substrate (figure 6, part B) over a part of its thickness or over all of its thickness, as explained above, then with the assembling of the two substrates 22 and 24 (which, as such, is not covered by the invention) .

For example, a heat treatment allows to separate the substrate 22 on the ion implantation layer 26 of hydrogen ions (figure 6, part D).

This results, on one hand in a unit made of the substrate 24 with a superficial layer 28 of material which comes from the initial substrate 22, and on the other hand in a substrate or a free portion 23 which also comes from the initial substrate 22 and which is reusable for subsequent operations. If the thickness over which the substrate 22 was routed or trimmed is greater than the thickness of the transplant layer 28, this substrate 22 can notably be subjected to a new ion or atom implantation, then a new transferring or transplanting stage after assembling with a new substrate 24, but without the need to perform a new routing or trimming stage.

The methods, such as is described above in connection with one of the figures 3-6, also apply in the case where the initial substrate 12 and 22 has the shape illustrated in figure 9, with a shoulder 25 on the edges of the wafer (not covered by the method according to the invention).

These shoulders define a stiffening located at a depth P, for example lying between 50 nm and 2 µm.

The routing stage allows to remove these shoulders.

An ion implantation stage, for the creating of a weakened plane 26, can take place before or after this routing or trimming stage: a wafer is thus obtained which is identical to the one represented in part B of figure 6. The following stages in figure 6 can thus be performed as described above.

BSOI or thick SOI type structures can also be created in an efficient manner. The thinning out stage is then mechanic and/or mechano-chemical.

According to another example, electronic components are made in a wafer such as the wafer 12 (figure 3A) over a superficial thickness, for example, between 1 and 10 µm.

We rout or trim via "surface edge grinding" the edge of the wafer over a thickness ed of 50 µm and along a width Ld of 3 mm.

This routing stage can be performed before surface preparation (for example via mechano-chemical levelling followed by chemical cleaning) and in order to reduce the number of cleansings before assembling.

Then the routed wafer (comprising the components) is bonded via molecular adhesion onto the support wafer. The structure is then annealed for example at a temperature of 300°C and for a time span of between a few minutes and a few hours.

The superficial wafer is then thinned out via surface edge grinding and mechano-chemical (figure 3, part D) and/or chemical polishing until a thickness de is obtained, for example, 10 µm.

A transplanted layer, comprising the components, transferred onto a support wafer is thus obtained.

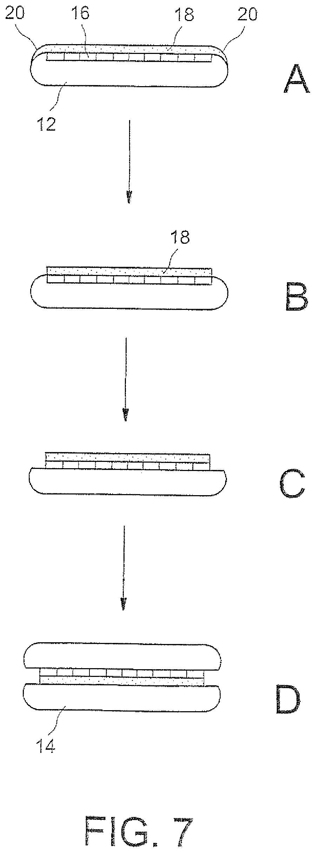

According to another embodiment, not covered by the method according to the invention, the wafer 12 comprises components 16 and is covered on its surface with a protective layer 18, for example an oxide layer 18 (figure 7, part A). This can also be a bonding layer.

A crown 20 is defined via lithography which will correspond to the routing zone. A local chemical etching allows to eliminate, on this zone, the protective layer 18 (figure 7, part B).

The edge of the substrate 12 is then etched (figure 7, part C), for example via chemical (ex. TMAH) or plasma etching.

The wafer is then cleaned, for example via chemical cleaning. According to an alternative, the cleaning is integrated into the chemical etching.

It can then proceed with the assembling on a wafer 14 as explained above (figure 7, part D).

According to an alternative, not covered by the method according to the invention, in figure 10A and 10B, a protective layer 18 initially coats the entire upper section of the wafer 12 as well as the edges 12-1 and 12-2, and possibly its lower section (in which case it coats the entire wafer).

The routing operation will allow to eliminate the lateral zones of this wafer such as the hatched zone in figure 10B. A possible scaling or clearing due to the routing operation occurs at the point M of the coating layer 18 or in a zone of this layer near this point. A scaling occurring on the wafer can generate defects, some of which can show on the surface of the wafer. A point of the surface to be assembled, such as point N, remains intact despite routing. The protective layer 18 can be eliminated after routing and before assembling.

Figures 8A-8D each represent a front view of a wafer 40 and 42 with a layer 41 and 43 of material around which routing was performed. This layer 41 and 43 is intended to be transplanted or transferred onto a second wafer, according to any one of the aforementioned embodiments. In figure 8A the wafer has a flat or a flattered zone 44.

An irregular routing is performed, as illustrated in figures 8C-8D. In these figures, the zones 50 and 51 represent zones or flats or flat surfaces which will allow to mark the support wafer. The zone 44 in figure 8A can also be used to mark the wafer.

Such a zone allows to provide indications regarding the nature of the wafer or an identification number of a batch to which the wafer belongs.

Irregular routing, such as in figures 8A, 8C and 8D is performed after assembling, thus using the standard routing technique such as is illustrated in figures 1A-1D, and possibly with one or two processed wafers, thus comprising all or part of a component or circuit. The other processing stages can be those already described above.

In particular, one of the wafers can have a chamfered edge, the routing can thus take place over a width at least equal to the width of the chamfered edge, measured on a plane parallel to that of the wafer.

The assembling can take place via molecular adhesion or via bonding.

Generally, the invention has the advantage of being able to be integrated into a method for manufacturing. This is notably the case when components are previously made in the wafers.

The invention also applies in the case of non-chamfered wafers. The other processing stages are similar to those described according to one or other of the embodiments described above or below.

The method set forth in the invention is also well suited to the manufacturing of BSOI type material, or even to the transplanting of a layer of III-V material onto silicon for example.

This said method can apply to the transplanting of III-V material such as AsGa or InP onto another material such as a semiconductor notably silicon.

This said method can also apply to the transplanting of semiconductor material such as Germanium or Germanium silicon (SiGe) onto a substrate made in another material such as a semiconductor, notably silicon.

Likewise, this method can be used to perform a transplanting of wafers of non-semiconductor material, for example wafers of piezoelectric material such as LiNbO3 or LiTaO3, which allows to obtain a perfectly routed thin film on a support of the same nature or of a different nature, for example a semiconductor substrate and notably silicon.

The wafers of material prepared and assembled according to the invention are wafers of "bulk" material. However, the invention applies to wafers that can contain all or part of a component, for example an electronic, and/or an electro-optic, and/or an optic, and/or a magnetic component or a MEMS.

## Claims

1. Method for assembling a first and a second wafer of material (40, 42) , at least one of the two wafers being made of a semiconductor material or of a piezoelectric material, said method comprising:
- an assembling stage of the first wafer and of the second wafer;
- then, a trimming stage of at least the periphery of the first wafer, thereby creating at least a flattened zone (50, 51, 44) on the periphery of the first wafer, in a plane perpendicular to a main surface of the first wafer.

2. Method as in claim 1, the trimming stage being performed over the entire thickness e of the first wafer, or over a thickness ed less than the thickness e of the first wafer.

3. Method as in claim 1 or 2, the first wafer being chamfered and comprising at least a chamfered edge (5).

4. Method as in claim 3, the trimming stage being performed over a width Ld, measured on a plane parallel to that of the first wafer, at least equal to the width L of the chamfered edge, measured on the same plane.

5. Method as in any of claims 1 to 4, the trimming stage being performed over a width Ld, measured on a plane parallel to that of the first wafer of between 100 µm and 5 mm.

6. Method as in any of the previous claims, further comprising a thinning out stage of one of the two wafers after the assembling stage.

7. Method as in any of claims 1 to 6, the assembling of the two wafers being performed via molecular adhesion or via bonding using an adhesive substance.

8. Method as in any of the previous claims, at least one of the two wafers having components or circuits (16).

9. Method as in any of the previous claims, the trimming being performed via mechanical or chemical or mechano-chemical etching or polishing or via plasma etching or via a combination of at least two of these types of etching.

## Patentansprüche

1. Verfahren zum Zusammenfügen eines ersten und eines zweiten Wafers aus einem Material (40, 42), wobei wenigstens einer von den zwei Wafern aus einem Halbleitermaterial oder einem piezoelektrischen Material hergestellt ist, wobei das Verfahren umfasst:
- einen Schritt des Zusammenfügens des ersten Wafers und des zweiten Wafers;
- dann, einen Schritt des Abgratens von wenigstens dem Umfang des ersten Wafers, wodurch wenigstens eine abgeflachte Zone (50, 51, 44) an dem Umfang des ersten Wafers erzeugt wird, in einer Ebene orthogonal zu einer Hauptoberfläche des ersten Wafers.

2. Verfahren nach Anspruch 1, wobei der Abgratungsschritt über die gesamte Dicke e des ersten Wafers durchgeführt wird, oder über eine Dicke ed, die kleiner ist als die Dicke e des ersten Wafers.

3. Verfahren nach Anspruch 1 oder 2, wobei der erste Wafer abgeschrägt ist und wenigstens eine abgeschrägte Kante (5) umfasst.

4. Verfahren nach Anspruch 3, wobei der Abgratungsschritt über eine Breite Ld durchgeführt wird, gemessen in einer Ebene parallel zu jener des ersten Wafers, die wenigstens gleich der Breite L der abgeschrägten Kante ist, gemessen in der gleichen Ebene.

5. Verfahren nach einem der Ansprüche 1 bis 4, wobei der Abgratungsschritt über eine Breite Ld, gemessen in einer Ebene parallel zu jener des ersten Wafers, zwischen 100 µm und 5 mm durchgeführt wird.

6. Verfahren nach einem der vorhergehenden Ansprüche, ferner umfassend einen Schritt des Abdünnens von einem der zwei Wafer nach dem Zusammenfügungsschritt.

7. Verfahren nach einem der Ansprüche 1 bis 6, wobei das Zusammenfügen der zwei Wafer mittels molekularer Adhäsion oder mittels einer Verbindung unter Verwendung einer Haftsubstanz durchgeführt wird.

8. Verfahren nach einem der vorhergehenden Ansprüche, wobei wenigstens einer der zwei Wafer Komponenten oder Schaltkreise (16) hat.

9. Verfahren nach einem der vorhergehenden Ansprüche, wobei die Abgratung mittels mechanischen oder chemischen oder mechanisch-chemischen Ätzens oder Polierens oder mittels Plasmaätzen oder mittels einer Kombination von wenigstens zwei dieser Ätztypen durchgeführt wird.

## Revendications

1. Procédé d'assemblage d'une première et d'une seconde plaquette de matériau (40, 42), au moins l'une des deux plaquettes étant constituée d'un matériau semiconducteur ou d'un matériau piézoélectrique, ledit procédé comprenant :
- une étape d'assemblage de la première plaquette et de la seconde plaquette de matériau ;
- puis, une étape de rognage d'au moins la périphérie de la première plaquette, pour ainsi créer au moins une zone aplatie (50, 51, 44) sur la périphérie de la première plaquette, dans un plan perpendiculaire à une surface principale de la première plaquette.

2. Procédé selon la revendication 1, l'étape de rognage étant réalisée sur toute l'épaisseur e de la première plaquette, ou sur une épaisseur ed inférieure à l'épaisseur e de la première plaquette.

3. Procédé selon la revendication 1 ou 2, la première plaquette étant chanfreinée et comprenant au moins un bord chanfreiné (5).

4. Procédé selon la revendication 3, l'étape de rognage étant réalisée sur une largeur Ld, mesurée sur un plan parallèle à celui de la première plaquette, au moins égale à la largeur L du bord chanfreiné, mesurée sur le même plan.

5. Procédé selon l'une quelconque des revendications 1 à 4, l'étape de rognage étant réalisée sur une largeur Ld, mesurée sur un plan parallèle à celui de la première plaquette comprise entre 100 µm et 5 mm.

6. Procédé selon l'une quelconque des revendications précédentes, comprenant en outre une étape d'amincissement de l'une des deux plaquettes après l'étape d'assemblage.

7. Procédé selon l'une quelconque des revendications 1 à 6, l'assemblage des deux plaquettes étant réalisé par adhérence moléculaire ou par liaison à l'aide d'une substance adhésive.

8. Procédé selon l'une quelconque des revendications précédentes, au moins l'une des deux plaquettes ayant des composants ou des circuits (16).

9. Procédé selon l'une quelconque des revendications précédentes, le rognage étant réalisé par gravure ou polissage mécanique ou chimique ou mécanochimique ou par gravure au plasma ou par une combinaison d'au moins deux de ces types de gravure.
